# FASCICULE DE BREVET EUROPEEN

(11) **EP 3 011 602 B1**
(45) Date de publication et mention de la délivrance du brevet: **19.04.2017**
(21) Numéro de dépôt: 14730887.8
(22) Date de dépôt: 16.06.2014
(51) Int. Cl.: H01L 31/0747, H01L 31/0745

(54) **CELLULE SOLAIRE A HETEROJONCTION DE SILICIUM**
SOLARZELLE MIT EINEM SILIKONHETEROÜBERGANG
SOLAR CELL WITH A SILICON HETEROJUNCTION

(30) Priorité: 17.06.2013 FR 1355649
(43) Date de publication de la demande: 27.04.2016
(73) Titulaire: Commissariat à l'Énergie Atomique et aux Énergies Alternatives, 75015 Paris (FR)
(72) Inventeur: COIGNUS, Jean, F-38000 Grenoble (FR)
(74) Mandataire: Regimbeau
(86) Numéro de dépôt international: PCT/EP2014/062553
(87) Numéro de publication internationale: WO 2014/202524

(56) Documents cités:
- FR-A1- 2 910 711
- US-A1- 2009 211 627
- US-A1- 2011 284 074
- US-A1- 2011 297 227
- US-A1- 2011 308 607
- US-A1- 2013 025 655

## Description

### DOMAINE DE L'INVENTION

La présente invention concerne une cellule solaire à hétérojonction de silicium ainsi qu'un procédé de fabrication d'une telle cellule.

### ARRIERE PLAN DE L'INVENTION

Dans une cellule solaire à hétérojonction de silicium (souvent désignée par l'acronyme SHJ du terme anglo-saxon « Silicon HeteroJunction solar cell »), le champ électrique interne indispensable à l'effet photovoltaïque est créé par une couche de silicium amorphe hydrogéné dopé p (noté conventionnellement a-Si:H(p)) déposée sur un substrat de silicium cristallin dopé n (noté conventionnellement c-Si(n)), contrairement à une structure homojonction classique dans laquelle le champ électrique interne est obtenu par une jonction silicium dopé p / silicium dopé n.

Inversement, il existe également des cellules à hétérojonction de silicium dans lesquelles le substrat de silicium cristallin est dopé p et la couche de silicium amorphe hydrogéné est dopée n.

En général, une couche de passivation, par exemple en silicium amorphe hydrogéné intrinsèque (noté conventionnellement a-Si:H(i)) est intercalée entre le substrat et la couche de silicium amorphe dopé, de manière à bénéficier des excellentes propriétés d'interface a-Si :H(i) / c-Si(n ou p) et d'augmenter la tension en circuit ouvert (Voc) de la cellule solaire.

La faible concentration de pièges recombinants aux interfaces s'explique par l'absence d'impuretés dopantes dans une couche a-Si:H(i).

Pour limiter l'absorption parasite des photons dans les couches amorphes, celles-ci présentent une épaisseur très faible et une couche d'un matériau transparent conducteur, tel qu'un oxyde transparent conducteur (OTC) est formée sur la face avant pour collecter latéralement les charges photogénérées vers les électrodes métalliques destinées à collecter le courant électrique produit.

Outre une faible résistivité électrique, la couche de matériau transparent conducteur doit présenter des propriétés optiques compatibles avec des exigences de haut rendement, à savoir d'une part un indice optique n compris entre celui de l'environnement extérieur et celui du silicium amorphe (pour la fonction d'anti-reflet) et d'autre part un indice optique k faible, traduisant une faible absorption des photons.

L'hétérojonction peut être située sur la face avant de la cellule (c'est-à-dire la face exposée au rayonnement solaire) ou bien sur la face arrière, opposée à la face avant.

Généralement, sur la face du substrat opposée à la face comprenant l'hétérojonction, la cellule comprend un empilement d'une couche de passivation et d'une couche de silicium amorphe dopé du même type que celui du substrat.

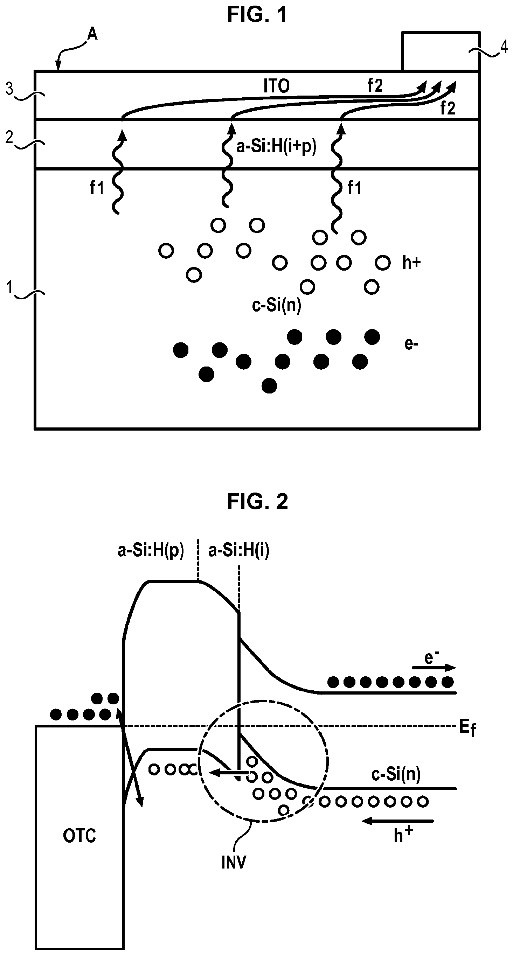

La figure 1 est un schéma de principe de la face avant A d'une cellule solaire à hétérojonction de silicium.

Le substrat de silicium cristallin est désigné par le repère 1.

Il s'agit sur la figure 1 d'un substrat en silicium dopé n et la jonction p/n est réalisée en face avant.

Le substrat 1 est recouvert successivement d'une couche de passivation, par exemple en silicium amorphe intrinsèque, et d'une couche de silicium amorphe dopé p, qui présentent chacune quelques nanomètres d'épaisseur. L'ensemble de ces deux couches amorphes est désigné par le repère 2.

Une couche 3 de matériau transparent conducteur recouvre la couche de silicium amorphe dopée p.

Enfin, une électrode métallique 4 est présente sur la face avant au contact de la couche de matériau transparent conducteur.

Des paires électrons e- / trous h+ sont générées dans le substrat 1 sous l'effet de l'absorption de photons.

Sous l'effet du champ électrique dû à l'hétérojonction, les trous h+ se déplacent vers la face avant, traversent la couche 2 de silicium amorphe et sont collectés par la couche 3 de matériau transparent conducteur (flèches f1 sensiblement perpendiculaires à la face avant A). Ils sont ensuite conduits vers l'électrode métallique 4 dans la couche 3 (flèches f2 sensiblement parallèles à la face avant A).

Il est reconnu dans la littérature que le compromis entre conductivité et transparence de la couche de matériau transparent conducteur est difficile à atteindre [1].

Dans le cas de l'oxyde transparent conducteur le plus utilisé, à savoir l'oxyde d'indium dopé à l'étain (ITO, acronyme du terme anglo-saxon « Indium Tin Oxide »), la modulation de la concentration de porteurs est assurée par le dopage en oxygène de la couche.

En effet, la présence d'une importante quantité d'oxygène au cours du dépôt de la couche d'ITO diminue le nombre de lacunes d'oxygène et contribue à diminuer la concentration de porteurs.

Une faible concentration de porteurs induit une plus grande résistivité électrique de la couche mais une meilleure transparence.

Inversement, un dopage en oxygène faible induit une excellente conductivité électrique de la couche (due à une forte concentration d'électrons) mais une absorption importante dans le domaine infrarouge.

L'amélioration du compromis électrique / optique de la couche d'ITO atteint ses limites après des années d'optimisation des procédés de dépôt.

Des matériaux alternatifs à l'ITO, notamment l'oxyde d'indium (10), l'oxyde d'indium dopé au tungstène (IWO), ou l'oxyde d'indium dopé au zinc, sont actuellement à l'étude et semblent prometteurs.

Toutefois, la technologie SHJ impose des contraintes strictes en ce qui concerne les conditions de dépôt de la couche de matériau transparent conducteur : ce dépôt doit en effet être réalisé à basse température et à faible puissance pour ne pas dégrader les couches de silicium amorphe sous-jacentes.

Ces contraintes de fabrication limitent donc l'étendue des voies d'exploration.

Un but de l'invention est d'améliorer encore le rendement d'une cellule solaire à hétérojonction de silicium.

### BREVE DESCRIPTION DE L'INVENTION

Conformément à l'invention, il est proposé une cellule solaire à hétérojonction de silicium, comprenant successivement :
- un substrat de silicium cristallin dopé,
- une couche de passivation,
- une couche de silicium amorphe dopé de type opposé à celui du substrat,
- une couche d'un matériau transparent conducteur,
ladite cellule étant caractérisée en ce qu'elle comprend, entre le substrat et la couche de passivation, une couche d'un matériau cristallin dit « à forte mobilité de porteurs minoritaires » dans lequel la mobilité (µₘ) des porteurs minoritaires du substrat est supérieure à la mobilité desdits porteurs minoritaires dans le substrat.

Par « silicium intrinsèque », on entend du silicium ne contenant aucun dopant ou tout au moins dans lequel aucun dopant n'a été introduit intentionnellement pendant la formation du matériau. En tout état de cause on considère que le silicium est intrinsèque si sa concentration en dopants actifs est inférieure à 1^{E}15 /cm³.

A cet effet, le dépôt du silicium intrinsèque sous forme amorphe ou cristalline est réalisé dans une enceinte non contaminée par des impuretés dopantes.

Par « silicium microdopé » on entend du silicium dont la concentration en dopants actifs est comprise entre 1^{E}15 et 1^{E}17 /cm³.

Par silicium dopé, on entend du silicium dont la concentration en dopants actifs est supérieure à 1^{E}17 /cm³.

Ladite couche de matériau à forte mobilité de porteurs minoritaires est en contact avec le substrat.

De manière particulièrement avantageuse, l'épaisseur de la couche de matériau à forte mobilité de porteurs minoritaires est choisie de sorte à être inférieure à l'épaisseur critique à partir de laquelle des défauts cristallins apparaissent dans ladite couche lorsque l'on fait croître ledit matériau par épitaxie sur le substrat de silicium cristallin.

De préférence, l'épaisseur de la couche de matériau à forte mobilité de porteurs minoritaires est comprise entre 3 et 25 nm.

Selon une forme d'exécution de l'invention, le substrat est dopé n, les porteurs minoritaires étant alors des trous.

Selon un mode de réalisation préféré, le matériau à forte mobilité de trous est un alliage de silicium et de germanium de type Si₁₋ₓGeₓ avec 0<x≤1.

Selon une autre forme d'exécution, le substrat est dopé p, les porteurs minoritaires étant alors des électrons.

Dans ce cas, le matériau à forte mobilité d'électrons est avantageusement un alliage GaAs ou InGaAs.

Selon une forme d'exécution particulièrement avantageuse de l'invention, ladite cellule comprend en outre, entre la couche de matériau à forte mobilité de porteurs minoritaires et la couche de passivation, une couche de silicium cristallin intrinsèque qui a pour effet d'améliorer la qualité de l'interface entre ladite couche et la couche de passivation.

L'épaisseur de ladite couche de silicium cristallin intrinsèque est avantageusement comprise entre 1 et 5 nm.

Un autre objet concerne un procédé de fabrication d'une cellule solaire telle que décrite ci-dessus.

Ledit procédé comprend la formation, sur un substrat de silicium cristallin dopé, des couches successives suivantes :
- une couche de passivation,
- une couche de silicium amorphe dopé de type opposé à celui du substrat,
- une couche d'un matériau transparent conducteur,
ledit procédé étant caractérisé en ce qu'il comprend, avant la formation desdites couches, la croissance par épitaxie sur le substrat d'une couche d'un matériau cristallin dit « à forte mobilité de porteurs minoritaires », dans lequel la mobilité (µₘ) des porteurs minoritaires du substrat est supérieure à la mobilité desdits porteurs minoritaires dans le substrat.

De manière particulièrement avantageuse, l'épaisseur de la couche de matériau à forte mobilité de porteurs minoritaires est choisie de sorte à être inférieure à l'épaisseur critique à partir de laquelle des défauts cristallins apparaissent dans ladite couche.

De préférence, l'épaisseur de la couche de matériau à forte mobilité de porteurs minoritaires est comprise entre 3 et 25 nm.

Selon une forme d'exécution de l'invention, le substrat est dopé n, les porteurs minoritaires étant alors des trous.

Selon un mode de réalisation préféré, le matériau à forte mobilité de trous est un alliage de silicium et de germanium de type Si₁₋ₓGeₓ avec 0<x≤1.

Selon une autre forme d'exécution, le substrat est dopé p, les porteurs minoritaires étant alors des électrons.

Dans ce cas, le matériau à forte mobilité d'électrons est avantageusement un alliage GaAs ou InGaAs.

Selon une forme d'exécution particulièrement avantageuse, le procédé comprend en outre la croissance par épitaxie, sur ladite couche de matériau à forte mobilité de porteurs minoritaires, d'une couche de silicium cristallin intrinsèque.

L'épaisseur de ladite couche de silicium cristallin intrinsèque est avantageusement comprise entre 1 et 5 nm.

### BREVE DESCRIPTION DES DESSINS

D'autres caractéristiques et avantages de l'invention ressortiront de la description détaillée qui va suivre, en référence aux dessins annexés sur lesquels :
- la figure 1 un schéma de principe de la face avant d'une cellule solaire à hétérojonction de silicium conventionnelle,
- la figure 2 illustre le diagramme de bandes de la face avant d'une cellule solaire à hétérojonction conventionnelle,
- la figure 3 est une vue en coupe de la face avant d'une cellule solaire à hétérojonction de silicium conforme à l'invention,
- la figure 4 présente l'évolution de l'épaisseur critique d'une couche d'un alliage silicium-germanium en fonction de la proportion de germanium dans l'alliage,
- la figure 5 est un schéma de principe de la face avant d'une cellule solaire à hétérojonction de silicium conforme à l'invention.

Il est précisé que pour des questions de clarté des illustrations, les épaisseurs des différentes couches ne sont pas représentées à l'échelle.

### DESCRIPTION DETAILLEE DE MODES DE REALISATION DE L'INVENTION

Il est proposé d'intercaler, sur la face de la cellule comprenant l'hétérojonction, une couche supplémentaire entre le substrat en silicium cristallin dopé selon un type et la couche de passivation, afin d'augmenter la conductivité dans une couche dite couche d'inversion présente à l'interface entre la couche de passivation et le substrat en silicium cristallin.

La présence de la couche supplémentaire est en effet destinée à favoriser un chemin de conduction parallèle à celui observé dans la couche de matériau transparent conducteur, ce qui permet de manière avantageuse d'utiliser un matériau transparent conducteur qui soit moins conducteur électriquement que ceux habituellement utilisés et donc meilleur optiquement.

Il est par exemple possible de moduler l'épaisseur de la couche de matériau transparent conducteur et/ou la conductivité intrinsèque dudit matériau afin de rendre ledit matériau meilleur optiquement et donc moins bon conducteur électriquement.

De manière générale, le matériau transparent conducteur peut être un oxyde transparent conducteur à base d'indium (tel que ITO, 10, IWO, etc.), qui présente un faible budget thermique de dépôt et un travail de sortie adapté.

Dans un oxyde transparent conducteur à base d'indium, le dopage oxygène suffit à moduler significativement le compromis conductivité/transparence.

La figure 2 illustre le diagramme de bandes de la face avant d'une cellule solaire à hétérojonction conventionnelle avec un substrat en silicium cristallin dopé n (c-Si(n)), une couche de passivation en silicium amorphe intrinsèque (a-Si :H(i)) et une couche de silicium amorphe dopée p (a-Si :H(p)).

La ligne en pointillés représente le niveau de Fermi E_{f}.

Comme on peut le voir sur ce diagramme, il existe en effet une couche d'inversion à l'interface entre la couche a-Si:H(i) et le substrat c-Si(n) [2, 3].

Cette couche d'inversion est désignée par la région entourée noté INV.

En raison du champ électrique interne imposé par la couche a-Si:H(p), la concentration en porteurs minoritaires du substrat (trous h+) est plus importante à l'interface que la concentration en porteurs majoritaires (électrons e-).

Bien que cette couche d'inversion ait été déjà mise en évidence dans des cellules à hétérojonction, elle n'est jusqu'à présent pas apparue comme un levier susceptible de permettre des améliorations de rendement.

Or, la Demanderesse se propose d'améliorer la conductivité de la couche d'inversion, afin de permettre un autre chemin de collecte des porteurs de charge que celui classiquement connu par le biais de la couche en matériau transparent conducteur (OTC) et illustré à la figure 1.

Ceci permet alors de s'affranchir du compromis électrique/optique trouvé jusqu'à présent pour la couche de matériau transparent conducteur, ce qui ouvre des perspectives d'amélioration du rendement des cellules SHJ.

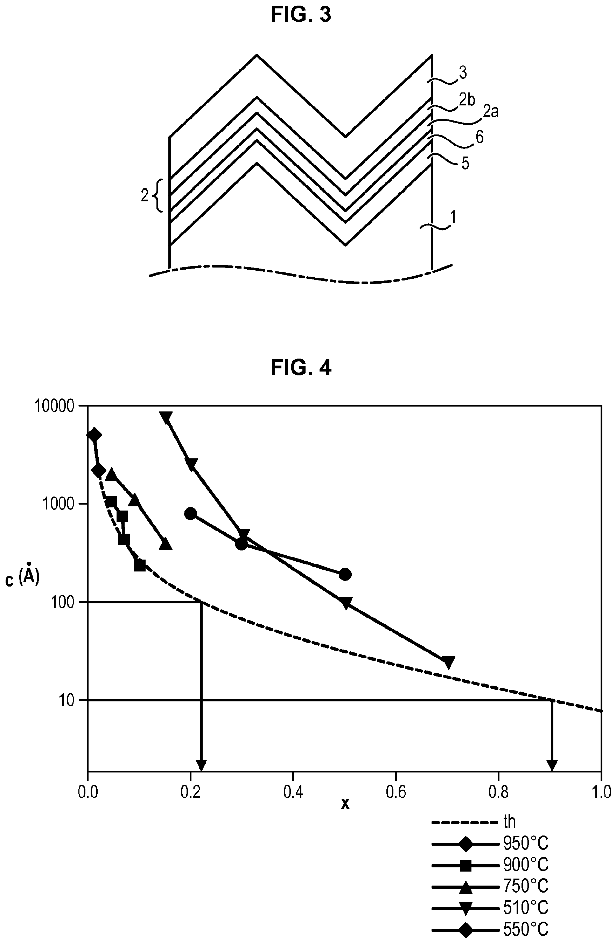

La figure 3 est une vue en coupe de la face avant d'une cellule solaire à hétérojonction de silicium conforme à l'invention.

Dans l'exemple décrit ici, le substrat est dopé n et le silicium amorphe est dopé p.

Dans ce cas, les porteurs minoritaires du substrat sont les trous.

Cependant, l'invention s'applique également à une cellule dans laquelle le substrat est dopé p et le silicium amorphe est dopé n.

Dans ce cas, les porteurs minoritaires du substrat sont les électrons.

Par ailleurs, l'exemple décrit ici concerne une cellule dans laquelle la jonction entre le substrat de silicium et le silicium amorphe est réalisée en face avant.

Cependant, l'invention s'applique également à une cellule dite « à émetteur inversé », pour laquelle la jonction entre le substrat de silicium et le silicium amorphe est réalisée en face arrière.

Comme on peut le voir sur la figure 3, la cellule comprend sur sa face avant, comme une cellule conventionnelle :
- un substrat 1 de silicium dopé n,
- une couche 2a de passivation ; selon un mode de réalisation, ladite couche est une couche de silicium amorphe intrinsèque (ou microdopé p),
- une couche 2b de silicium amorphe dopé p, l'empilement des couches 2a et 2b étant désigné par le repère 2,
- une couche 3 d'un matériau transparent conducteur.

Par ailleurs, la cellule solaire à hétérojonction de silicium peut aussi comporter d'autres couches du côté opposé du substrat : une couche de passivation, une couche de silicium amorphe dopé selon le même type que celui du substrat (donc ici n) et une couche en matériau transparent conducteur.

Dans cette cellule, une couche supplémentaire est aussi interposée entre le substrat 1 et la couche 2a de passivation.

Cette couche supplémentaire est une couche 5 d'un matériau cristallin dit « à forte mobilité de trous », et elle est destinée à améliorer la conduction dans la couche d'inversion.

La mobilité de porteurs (trous ou électrons) est généralement notée µₘ.

Par « forte mobilité de trous » on entend dans le présent texte une mobilité de trous strictement supérieure à la mobilité des trous (qui sont les porteurs minoritaires du substrat de type n) dans le substrat de silicium, qui est de l'ordre de 450 cm²/Vs.

Parmi, les matériaux présentant une mobilité de trous supérieure à celle du silicium, on peut citer en particulier, un alliage de silicium et de germanium, le germanium (µₘ = 1900 cm²/Vs), l'antimoniure de gallium GaSb (µₘ = 850 cm²/Vs), ou encore l'antimoniure d'indium (µₘ = 1250 cm²/Vs).

Inversement, dans le cas où le substrat de silicium est dopé p, les porteurs minoritaires dudit substrat sont des électrons.

Parmi, les matériaux présentant une mobilité d'électrons supérieure à celle du substrat de silicium, on peut citer en particulier, un alliage GaAs ou InGaAs.

L'invention met donc plus généralement en oeuvre un matériau « à forte mobilité de porteurs minoritaires du substrat », dans lequel la mobilité desdits porteurs minoritaires est strictement supérieure à la mobilité desdits porteurs dans le substrat.

Il convient cependant de relever que la mobilité des trous ou des électrons dans ces matériaux sous forme d'une couche épitaxiée sur un substrat de silicium cristallin est différente de leur mobilité intrinsèque.

En effet, les désaccords de maille avec le silicium induisent une contrainte mécanique dans la couche épitaxiée, qui modifie les propriétés de conduction de la couche.

L'homme du métier est en mesure, pour un matériau envisagé, de fabriquer par épitaxie une couche de ce matériau sur un substrat de silicium cristallin et de mesurer la mobilité des trous ou des électrons dans une telle couche, par exemple par une mesure par effet Hall.

D'autre part, la contrainte mécanique imposée par le paramètre de maille du silicium peut être source de défauts à l'interface et de dislocations.

Ces défauts et dislocations dépendent de l'épaisseur de la couche épitaxiée.

De manière connue en elle-même, on appelle épaisseur critique l'épaisseur maximale en-dessous de laquelle la couche épitaxiée est exempte de défauts cristallins.

La figure 4 illustre l'évolution de l'épaisseur critique E_{c} d'un alliage silicium-germanium Si₁₋ₓGeₓ en fonction de la concentration x en germanium, pour différentes températures d'épitaxie. Ces données sont issues de [4].

Ainsi, 10 nm de SiGe comportant 20% de germanium peuvent être épitaxiés sans apparition de défauts, l'épaisseur critique chutant à 1 nm pour une concentration de germanium de 90%.

Il convient donc de prendre en compte à la fois l'épaisseur visée et la concentration en germanium.

Dans le cas où le substrat est dopé n, l'alliage SiGe est un matériau préféré pour la mise en oeuvre de l'invention, car l'épitaxie de ce matériau est parfaitement maîtrisée (technique de dépôt chimique en phase vapeur ou CVD, acronyme du terme anglo-saxon « Chemical Vapor Déposition »).

En outre, le budget thermique impliqué par l'épitaxie de cette couche n'a pas d'incidence sur les couches de silicium amorphe car celles-ci sont formées ultérieurement.

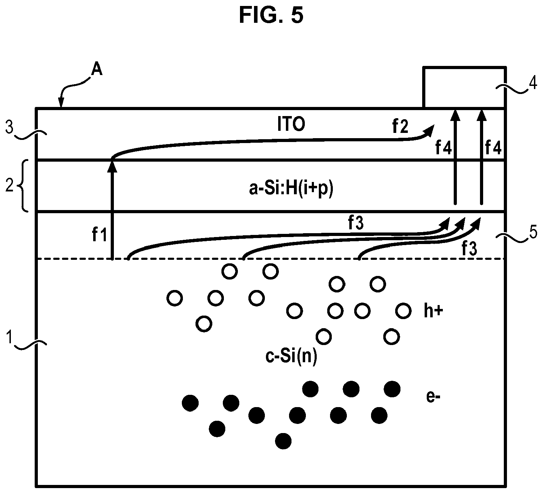

La figure 5 est un schéma de principe de la face avant d'une cellule solaire à hétérojonction de silicium conforme à l'invention (le substrat est ici dopé de type n).

Du fait de l'insertion du matériau à forte mobilité de trous entre le substrat de silicium cristallin et la couche de silicium amorphe, un autre chemin de conduction a été favorisé dans la cellule. Il s'agit d'un chemin parallèle au chemin observé dans la couche de matériau transparent conducteur.

Des paires électrons e- / trous h+ sont générées dans le substrat 1 sous l'effet de l'absorption de photons.

Sous l'effet du champ électrique dû à l'hétérojonction, les trous h+ se déplacent vers la face avant.

De manière conventionnelle, une partie des trous h+ traversent la couche 2 de silicium amorphe et sont collectés par la couche 3 de matériau transparent conducteur (flèche f1 sensiblement perpendiculaire à la face avant A). Ils sont ensuite conduits vers l'électrode métallique 4 dans la couche 3 (flèche f2 sensiblement parallèle à la face avant A).

Cependant, du fait de la présence de la couche à forte mobilité de trous à l'interface entre le substrat 1 et la couche 2 de silicium amorphe, une partie des trous h+ est conduite dans la couche 5 à forte mobilité de trous, sous la couche de silicium amorphe (flèches f3), puis ces trous traversent la couche de silicium amorphe et la couche de matériau transparent conducteur au droit de l'électrode métallique 4 (flèches f4).

La couche de matériau à forte mobilité de trous a ainsi pour effet d'améliorer la conductivité de la couche d'inversion dans la cellule solaire.

Dans le cas d'un substrat dopé p, la couche de matériau à forte mobilité d'électrons procure ce même effet.

Dans une cellule conforme à l'invention, la part de charges collectées par le matériau transparent conducteur diminue donc au profit celle de la couche d'inversion.

Ceci permet de diminuer la conductivité de la couche de matériau transparent conducteur sans dégrader le facteur de forme (FF) de la cellule solaire, et par conséquent d'améliorer les propriétés optiques de la couche de matériau transparent conducteur et le courant de court-circuit (Isc) de la cellule.

En outre, l'amélioration de la collecte latérale de charges permet d'augmenter l'espacement entre les électrodes métalliques et diminuer ainsi l'ombrage de la cellule, de sorte qu'un gain en courant de court-circuit est escompté.

Compte tenu des contraintes des cellules à haut rendement, qui imposent de préserver la qualité des interfaces et des matériaux constituant la cellule, la couche de matériau à forte mobilité de porteurs minoritaires est réalisée par épitaxie sur le substrat de silicium cristallin, après texturation et nettoyage de celui-ci.

D'autre part, comme expliqué plus haut, l'épaisseur de la couche 5 de matériau à forte mobilité de porteurs minoritaires est suffisamment fine pour éviter l'apparition de dislocations.

En fonction du taux de dopage du substrat 1 et du matériau choisi pour la couche 5, l'épaisseur de la couche 5 est comprise entre 3 et 25 nm, de préférence entre 5 et 20 nm.

L'empilement de la couche de passivation, de la couche de silicium amorphe dopé de type opposé à celui du substrat et de la couche de matériau transparent conducteur est ensuite réalisé de manière conventionnelle.

De manière avantageuse, avant de réaliser ledit empilement, on peut déposer sur la couche de matériau à forte mobilité de porteurs minoritaires une couche 6 de silicium cristallin intrinsèque très fine.

L'épaisseur de ladite couche de silicium cristallin intrinsèque est typiquement comprise entre 1 et 5 nm.

Cette couche 6 a pour fonction de préserver la qualité de l'interface a-Si:H(i) - c-Si.

De manière connue en elle-même, la réalisation de l'empilement des couches amorphes et de la couche de matériau transparent conducteur comprend typiquement les étapes suivantes :
- sur la face comprenant l'hétérojonction, dépôt de la couche 2a de passivation, par exemple en a-Si:H intrinsèque ou micro-dopé de type opposé à celui du substrat, cette couche étant déposée sur la couche 5 de matériau à forte mobilité de porteurs minoritaires ou, le cas échéant, sur la couche 6 de silicium cristallin intrinsèque. Ce dépôt peut être réalisé par PECVD (acronyme du terme anglo-saxon « Plasma-Enhanced Chemical Vapor Déposition »). L'épaisseur de la couche 2a est typiquement comprise entre 5 et 15 nm.
- dépôt, sur la couche 2a de passivation, de la couche 2b de a-Si:H dopé de type opposé à celui du substrat. Ce dépôt peut également être réalisé par PECVD. L'épaisseur de la couche 2b est typiquement comprise entre 2 et 10 nm.
- sur la face opposée à l'hétérojonction, dépôt d'une couche de passivation, par exemple en a-Si:H intrinsèque ou micro-dopé du même type que celui du substrat. Ce dépôt peut être réalisé par PECVD. L'épaisseur de ladite couche est typiquement comprise entre 2 et 15 nm.
- dépôt, sur ladite couche de passivation, d'une couche de a-Si:H dopé du même type que celui du substrat. Ce dépôt peut également être réalisé par PECVD. L'épaisseur de ladite couche est typiquement comprise entre 5 et 30 nm.
- sur la face avant, dépôt de la couche 3 de matériau transparent conducteur, par exemple d'ITO. Ce dépôt peut être réalisé par PVD (acronyme du terme anglo-saxon « Physical Vapor Déposition »). L'épaisseur de la couche 3 est typiquement comprise entre 50 et 150 nm.
- sur la face arrière, dépôt d'une couche de matériau transparent conducteur, par exemple d'ITO. Ce dépôt peut être réalisé par PVD. L'épaisseur de ladite couche est typiquement comprise entre 50 et 150 nm.
- réalisation des électrodes par métallisation de la face avant et de la face arrière, par exemple par sérigraphie.

Comme exposé plus haut, l'invention n'est pas limitée à une cellule solaire dont le substrat est dopé n et dont l'hétérojonction est réalisée sur la face avant, mais s'applique également à des cellules solaires SHJ dont le substrat est dopé p et/ou dont l'hétérojonction est réalisée sur la face arrière.

### REFERENCES

[1] ZC Holman et al., IEEE Journal of Photovoltaics 2, p.7, 2012
[2] JP Kleider et al., Nanoscale Research Letters 6, p.152, 2011
[3] JV. Li et al., Journal of Applied Physics 110, 114502, 2011
[4] Y. Bogumilowicz, Thèse de Doctorat 2005

## Revendications

1. Cellule solaire à hétérojonction de silicium, comprenant successivement :
- un substrat (1) de silicium cristallin dopé,
- une couche (2a) de passivation,
- une couche (2b) de silicium amorphe dopé de type opposé à celui du substrat (1),
- une couche (3) d'un matériau transparent conducteur,
ladite cellule étant **caractérisée en ce qu'**elle comprend, entre le substrat (1) et la couche (2a) de passivation, une couche (5) d'un matériau cristallin dit à forte mobilité de porteurs minoritaires dans lequel la mobilité des porteurs minoritaires du substrat (1) est supérieure à la mobilité desdits porteurs minoritaires dans le substrat (1).

2. Cellule solaire selon la revendication 1, **caractérisée en ce que** ladite couche (5) de matériau à forte mobilité de porteurs minoritaires est en contact avec le substrat (1).

3. Cellule solaire selon l'une des revendications 1 ou 2, **caractérisée en ce que** l'épaisseur de la couche (5) de matériau à forte mobilité de porteurs minoritaires est choisie de sorte à être inférieure à l'épaisseur critique à partir de laquelle des défauts cristallins apparaissent dans ladite couche (5) lorsque l'on fait croître ledit matériau par épitaxie sur le substrat (1) de silicium cristallin.

4. Cellule solaire selon l'une des revendications 1 à 3, **caractérisée en ce que** l'épaisseur de la couche (5) de matériau à forte mobilité de porteurs minoritaires est comprise entre 3 et 25 nm.

5. Cellule solaire selon l'une des revendications 1 à 4, **caractérisée en ce que** le substrat (1) est dopé n, les porteurs minoritaires étant alors des trous et **en ce que** le matériau à forte mobilité de porteurs minoritaires est un alliage de silicium et de germanium de type Si₁₋ₓGeₓ avec 0<x≤1.

6. Cellule solaire selon l'une des revendications 1 à 4, **caractérisée en ce que** le substrat (1) est dopé p, les porteurs minoritaires étant alors des électrons et **en ce que** le matériau à forte mobilité de porteurs minoritaires est un alliage GaAs ou InGaAs.

7. Cellule solaire selon l'une des revendications 1 à 6, **caractérisée en ce qu'**elle comprend en outre, entre la couche (5) de matériau à forte mobilité de porteurs minoritaires et la couche (2a) de passivation, une couche (6) de silicium cristallin intrinsèque.

8. Cellule solaire selon la revendication 7, **caractérisée en ce que** l'épaisseur de la couche (6) de silicium cristallin intrinsèque est comprise entre 1 et 5 nm.

9. Cellule solaire selon l'une des revendications 1 à 8, **caractérisée en ce que** la couche (2a) de passivation est une couche de silicium amorphe intrinsèque ou microdopé de type opposé à celui du substrat (1).

10. Procédé de fabrication d'une cellule solaire à hétérojonction de silicium, comprenant la formation, sur un substrat (1) de silicium cristallin dopé, des couches successives suivantes :
- une couche (2a) de passivation,
- une couche (2b) de silicium amorphe dopé de type opposé à celui du substrat (1),
- une couche (3) d'un matériau transparent conducteur,
ledit procédé étant **caractérisé en ce qu'**il comprend, avant la formation desdites couches (2a, 2b, 3), la croissance par épitaxie sur le substrat (1) d'une couche (5) d'un matériau cristallin, dit à forte mobilité de porteurs minoritaires, dans lequel la mobilité des porteurs minoritaires du substrat (1) est supérieure à la mobilité desdits porteurs minoritaires dans le substrat (1).

11. Procédé selon la revendication 10, **caractérisé en ce que** l'épaisseur de la couche (5) de matériau à forte mobilité de porteurs minoritaires est choisie de sorte à être inférieure à l'épaisseur critique à partir de laquelle des défauts cristallins apparaissent dans ladite couche (5).

12. Procédé selon l'une des revendications 10 ou 11, **caractérisé en ce que** l'épaisseur de la couche (5) de matériau à forte mobilité de porteurs minoritaires est comprise entre 3 et 25 nm.

13. Procédé selon l'une des revendications 10 à 12, **caractérisé en ce que** le substrat (1) est dopé n, les porteurs minoritaires étant alors des trous et **en ce que** le matériau à forte mobilité de porteurs minoritaires est un alliage de silicium et de germanium de type Si₁₋ₓGeₓ avec 0<x≤1.

14. Procédé selon l'une des revendications 10 à 12, **caractérisé en ce que** le substrat (1) est dopé p, les porteurs minoritaires étant alors des électrons et **en ce que** le matériau à forte mobilité de porteurs minoritaires est un alliage GaAs ou InGaAs.

15. Procédé selon l'une des revendications 10 à 14, **caractérisé en ce qu'**il comprend la croissance par épitaxie, sur ladite couche (5) de matériau à forte mobilité de porteurs minoritaires, d'une couche (6) de silicium cristallin intrinsèque.

## Patentansprüche

1. Silizium-Hetero-Junction-Solarzellen, umfassend aufeinander folgend:
- ein Substrat (1) aus dotiertem kristallinem Silizium,
- eine Passivierungsschicht (2a),
- eine Schicht (2b) aus dotiertem amorphem Silizium eines Typs, der demjenigen des Substrats (1) gegenüberliegt,
- eine Schicht (3) aus einem leitenden transparenten Material,
wobei die Zelle **dadurch gekennzeichnet ist, dass** sie, zwischen dem Substrat (1) und der Passivierungsschicht (2a), eine Schicht (5) aus einem kristallinem Material umfasst, bezeichnet als mit hoher Beweglichkeit von Minoritätsträgern, in denen die Beweglichkeit der Minoritätsträger des Substrats (1) größer als die Beweglichkeit der Minoritätsträger im Substrat (1) ist.

2. Solarzelle nach Anspruch 1, **dadurch gekennzeichnet, dass** die Schicht (5) aus Material mit hoher Beweglichkeit von Minoritätsträgern mit dem Substrat (1) in Kontakt ist.

3. Solarzelle nach einem der Ansprüche 1 oder 2, **dadurch gekennzeichnet, dass** die Dicke der Schicht (5) aus Material mit hoher Beweglichkeit von Minoritätsträgern derart ausgewählt ist, dass sie geringer als die kritische Dicke ist, ab der kristalline Fehler in der Schicht (5) auftreten, wenn das Material durch Epitaxie auf dem Substrat (1) aus kristallinem Silizium wachsen gelassen wird.

4. Solarzelle nach einem der Ansprüche 1 bis 3, **dadurch gekennzeichnet, dass** die Dicke der Schicht (5) aus Material mit hoher Beweglichkeit von Minoritätsträgern im Bereich zwischen 3 und 25 nm liegt.

5. Solarzelle nach einem der Ansprüche 1 bis 4, **dadurch gekennzeichnet, dass** das Substrat (1) n-dotiert ist, wobei die Minoritätsträger dann Löcher sind, und dadurch, dass das Material mit hoher Beweglichkeit von Minoritätsträgern eine Legierung aus Silizium und Germanium vom Typ Si₁₋ₓGeₓ mit 0 < x ≤ 1 ist.

6. Solarzelle nach einem der Ansprüche 1 bis 4, **dadurch gekennzeichnet, dass** das Substrat (1) p-dotiert ist, wobei die Minoritätsträger dann Elektronen sind, und dadurch, dass das Material mit hoher Beweglichkeit von Minoritätsträgern eine GaAs- oder InGaAs-Legierung ist.

7. Solarzelle nach einem der Ansprüche 1 bis 6, **dadurch gekennzeichnet, dass** sie außerdem zwischen der Schicht (5) aus Material mit hoher Beweglichkeit von Minoritätsträgern und der Passivierungsschicht (2a) eine Schicht (6) aus intrinsischem kristallinem Silizium umfasst.

8. Solarzelle nach Anspruch 7, **dadurch gekennzeichnet, dass** die Dicke der Schicht (6) aus intrinsischem kristallinem Silizium im Bereich zwischen 1 und 5 nm liegt.

9. Solarzelle nach einem der Ansprüche 1 bis 8, **dadurch gekennzeichnet, dass** die Passivierungsschicht (2a) eine Schicht aus intrinsischem amorphem Silizium oder mikrodotiert eines Typs ist, der demjenigen des Substrats (1) gegenüberliegt.

10. Verfahren zur Herstellung einer Silizium-Hetero-Junction-Solarzelle, umfassend das Bilden, auf einem Substrat (1) aus dotiertem kristallinem Silizium, der folgenden aufeinander folgenden Schichten:
- einer Passivierungsschicht (2a),
- einer Schicht (2b) aus dotiertem amorphem Silizium eines Typs, der demjenigen des Substrats (1) gegenüberliegt,
- einer Schicht (3) aus einem leitenden transparenten Material,
wobei das Verfahren **dadurch gekennzeichnet ist, dass** es, vor dem Bilden der Schichten (2a, 2b, 3), das Wachstum durch Epitaxie auf dem Substrat (1) einer Schicht (5) aus einem kristallinen Material, bezeichnet als mit hoher Beweglichkeit von Minoritätsträgern, wobei die Beweglichkeit der Minoritätsträger des Substrats (1) größer als die Beweglichkeit der Minoritätsträger im Substrat (1) ist, umfasst.

11. Verfahren nach Anspruch 10, **dadurch gekennzeichnet, dass** die Dicke der Schicht (5) aus Material mit hoher Beweglichkeit von Minoritätsträgern derart ausgewählt ist, dass sie geringer als die kritische Dicke ist, ab der kristalline Fehler in der Schicht (5) auftreten.

12. Verfahren nach einem der Ansprüche 10 oder 11, **dadurch gekennzeichnet, dass** die Dicke der Schicht (5) aus Material mit hoher Beweglichkeit von Minoritätsträgern zwischen 3 und 25 nm liegt.

13. Verfahren nach einem der Ansprüche 10 bis 12, **dadurch gekennzeichnet, dass** das Substrat (1) n-dotiert ist, wobei die Minoritätsträger dann Löcher sind, und dadurch, dass das Material mit hoher Beweglichkeit von Minoritätsträgern eine Legierung aus Silizium und Germanium vom Typ Si₁₋ₓGeₓ mit 0 < x ≤ 1 ist.

14. Verfahren nach einem der Ansprüche 10 bis 12, **dadurch gekennzeichnet, dass** das Substrat (1) p-dotiert ist, wobei die Minoritätsträger dann Elektronen sind, und dadurch, dass das Material mit hoher Beweglichkeit von Minoritätsträgern eine GaAs- oder InGaAs-Legierung ist.

15. Verfahren nach einem der Ansprüche 10 bis 14, **dadurch gekennzeichnet, dass** es das Wachstum durch Epitaxie auf der Schicht (5) aus Material mit hoher Beweglichkeit von Minoritätsträgern einer Schicht (6) aus intrinsischem kristallinem Silizium umfasst.

## Claims

1. Silicon heterojunction solar cell, successively comprising:
- a substrate (1) of doped crystalline silicon,
- a passivation layer (2a),
- a layer (2b) of doped amorphous silicon of opposite type to that of the substrate (1),
- a layer (3) of transparent conducting material,
said cell being **characterised in that** it comprises, between the substrate (1) and the passivation layer (2a), a layer (5) of crystalline material having so-called high minority carrier mobility wherein the mobility of the substrate (1) minority carriers is greater than the mobility of said minority carriers in the substrate (1).

2. Solar cell according to claim 1, **characterised in that** said layer (5) of material having high minority carrier mobility is in contact with the substrate (1).

3. Solar cell according to one of claims 1 or 2, **characterised in that** the thickness of the layer (5) of material having high minority carrier mobility is selected so that it is less than the critical thickness from which crystalline defects occur in said layer (5) when said material is grown by epitaxy on the crystalline silicon substrate (1).

4. Solar cell according to one of claims 1 to 3, **characterised in that** the thickness of the layer (5) of material having high minority carrier mobility is between 3 and 25 nm.

5. Solar cell according to one of claims 1 to 4, **characterised in that** the substrate (1) is n-doped, the minority carriers then being holes and **in that** the material having high minority carrier mobility is an alloy of silicon and germanium of Si₁₋ₓGeₓ type where 0<x≤1.

6. Solar cell according to one of claims 1 to 4, **characterised in that** the substrate (1) is p-doped, the minority carriers then being electrons and **in that** the material having high minority carrier mobility is a GaAs or InGaAs alloy.

7. Solar cell according to one of claims 1 to 6, **characterised in that** it further comprises, between the layer (5) of material having high minority carrier mobility and the passivation layer (2a), a layer (6) of intrinsic crystalline silicon.

8. Solar cell according to claim 7, **characterised in that** the thickness of the layer (6) of intrinsic crystalline silicon is between 1 and 5 nm.

9. Solar cell according to one of claims 1 to 8, **characterised in that** the passivation layer (2a) is a layer of intrinsic or micro-doped amorphous silicon of opposite type to that of the substrate (1).

10. Process for fabricating a silicon heterojunction solar cell comprising the formation on a doped crystalline silicon substrate (1) of the following successive layers:
- a passivation layer (2a),
- a layer (2b) of doped amorphous silicon of opposite type to that of the substrate (1),
- a layer (3) of transparent conducting material,
said process being **characterised in that**, before the formation of said layers (2a, 2b, 3), it comprises epitaxial growth on the substrate (1) of a layer (5) of crystalline material having so-called high minority carrier mobility wherein the mobility of the substrate (1) minority carriers is greater than the mobility of said minority carriers in the substrate (1).

11. Process according to claim 12, **characterised in that** the thickness of the layer (5) of material having high minority carrier mobility is selected so that it is less than the critical thickness from which crystalline defects occur in said layer (5).

12. Process according to one of claims 10 or 11, **characterised in that** the thickness of the layer (5) having high minority carrier mobility is between 3 and 25 nm.

13. Process according to one of claims 10 to 12, **characterised in that** the substrate (1) is n-doped, the minority carriers then being holes and **in that** the material with high minority carrier mobility is an alloy of silicon and germanium of Si₁₋ₓGeₓ type where 0<x≤1.

14. Process according to one of claims 10 to 12, **characterised in that** the substrate (1) is p-doped, the minority carriers then being electrons and **in that** the material having high minority carrier mobility is a GaAs or InGaAs alloy.

15. Process according to one of claims 10 to 14, **characterised in that** it comprises the epitaxial growth of a layer (6) of intrinsic crystalline silicon on said layer (5) of material having high minority carrier mobility.
